# EUROPÄISCHE PATENTSCHRIFT

(11) **EP 1 030 311 B1**
(45) Veröffentlichungstag und Bekanntmachung des Hinweises auf die Patenterteilung: **02.02.2005**
(21) Anmeldenummer: 00103532.8
(22) Anmeldetag: 18.02.2000
(51) Int. Cl.: G11C 7/18, G11C 5/14, G11C 5/02

(54) **Decoder-Anschlussanordnung für Speicherchips mit langen Bitleitungen**
Decoder connection for memory chips with long bit lines
Connection de décodeur pour mémoire à longues lignes de bit

(30) Priorität: 19.02.1999 DE 19907176
(43) Veröffentlichungstag der Anmeldung: 23.08.2000
(73) Patentinhaber: Infineon Technologies AG, 81541 München (DE)
(72) Erfinder: Feurle, Robert, 85579 Neubiberg (DE); Mandel, Sabine, 81369 München (DE); Schneider, Helmut, 80993 München (DE)
(74) Vertreter: Müller - Hoffmann & Partner

(56) Entgegenhaltungen:
- EP-A- 0 523 995
- US-A- 5 091 887

## Beschreibung

Die vorliegende Erfindung betrifft eine Decoder-Anschlußanordnung für Speicherchips mit
- in einer ersten Richtung verlaufenden langen Bitleitungen,
- die Bitleitungen in einem Speicherzellenfeld kreuzenden und in einer zweiten Richtung verlaufenden Wortleitungen,
- Wortleitungs-Decodern, die in einem Decoderbereich liegen und eine erste Metallisierungsebene bilden, wobei der Decoderbereich an einen in der ersten Richtung verlaufenden Rand des Speicherzellenfeldes angrenzt, und
- Versorgungsleitungen für die Decoder, die im Decoderbereich in einer über der ersten Metallisierungsebene liegenden zweiten Metallisierungsebene geführt sind, wobei zwischen den beiden Metallisierungsebenen jeweils durch Kontaktierungen an Seitenrändern des Decoderbereiches vorgesehen sind, wobei im Speicherzellenfeld die Bitleitungen in einem Twist-Bereich einen Twist bilden. Eine solche Anordnung ist z.B. aus US-A-5 091 887 bekannt.

Array-Segmente von integrierten Halbleiterspeichern und damit Speicherzellenfelder sollen möglichst groß gestaltet werden, um in jedem einzelnen Speicherzellenfeld möglichst viel Information speichern zu können. Mit größer werdenden, zusammenhängenden Array-Segmenten werden aber auch Zeilen-Decoder bzw. Zeilentreiber länger, so daß es zunehmend schwieriger wird, diese Decoder niederohmig mit Stromversorgungsnetzen zu verbinden.

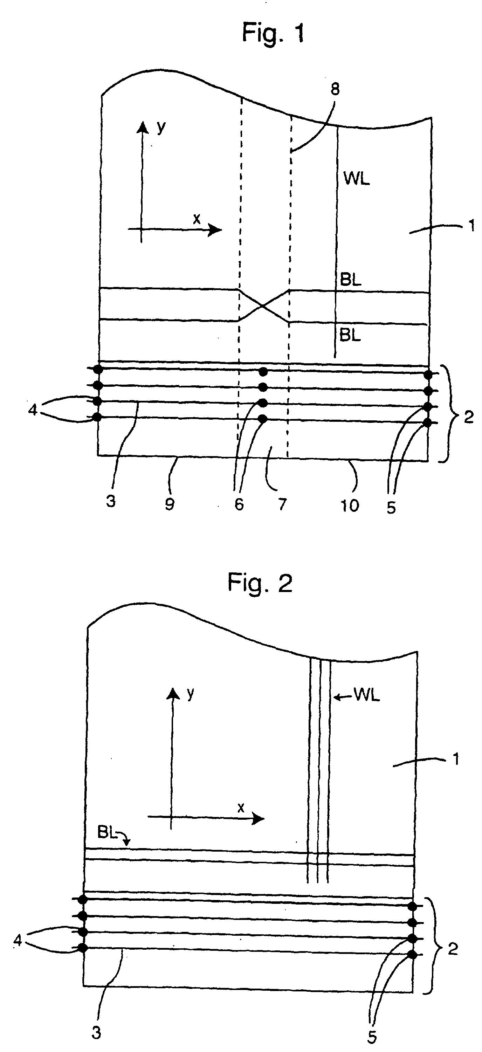

Gegenwärtig sind die Zeilen-Decoder, wie dies eingangs angedeutet ist, parallel zu den Bitleitungen am Rand eines Speicherzellenfeldes vorgesehen und dabei jeweils nur an ihren Enden über Durchkontaktierungen mit einem Stromversorgungsnetz verbunden. Eine derartige bestehende Anordnung ist in Fig. 2 gezeigt: in einem Speicherzellenfeld 1 verlaufen Wortleitungen WL in y-Richtung, während Bitleitungen BL in x-Richtung angeordnet sind. Zur Vereinfachung der Zeichnung sind nur eine Wortleitung WL bzw. zwei Bitleitungen BL dargestellt. Parallel zu den Bitleitungen BL ist am Rand des Speicherzellenfeldes 1 in der x-Richtung ein Decoderbereich 2 vorgesehen, in welchem die einzelnen Wortleitungen WL und deren Decoder äußerst eng zueinander liegen. Oberhalb dieser, eine erste Metallisierungsebene bildenden Decoder ist, isoliert durch eine Siliziumdioxidschicht, in einer zweiten Metallisierungsebene eine Reihe von zueinander parallelen Stromversorgungsleitungen 3 vorgesehen. Diese Stromversorgungsleitungen 3 sind mit den Decodern lediglich am Rand des Decoderbereiches 3 über Durchkontaktierungen 4, 5 die durch die Siliziumdioxidschicht verlaufen, elektrisch verbunden. Es ist nicht möglich, solche Durchkontaktierungen 4, 5 auch im Verlauf der Stromversorgungsleitungen 3, etwa in deren Mitte, vorzusehen, was darauf beruht, daß in der darunterliegenden Metallisierungsebene die einzelnen Decoder bzw. deren Wortleitungen eng nebeneinanderliegen. Bestehende Decoder-Anschlußanordnungen haben also Durchkontaktierungen 4, 5 lediglich an den Rändern der Decoderbereiche 2, welche an ein Speicherzellenfeld 1 angrenzen.

Es ist nun von großer Bedeutung, daß die einzelnen Decoder möglichst niederohmig mit diesen Stromversorgungsleitungen 3 verbunden werden, was derzeit durch die in Fig. 2 gezeigte beidseitige Durchkontaktierung 4 bzw. 5 an den beiden Enden des Decoderbereiches 2 geschieht. Andere Möglichkeiten bestehen darin, die Stromversorgungsleitungen 3 durch möglichst breite Metallbahnen auszuführen oder die Decoder an beiden Seiten der Bitleitungen (d.h. in der Fig. 2 oben und unten) vorzusehen.

Alle diese Maßnahmen sind aber mit einem höheren Flächenbedarf verbunden, was äußerst unerwünscht ist.

Es ist daher Aufgabe der vorliegenden Erfindung, eine Decoder-Anschlußanordnung der eingangs genannten Art so zu verbessern, daß diese ohne zusätzlichen Flächenbedarf möglichst niederohmig an Stromversorgungsleitungen anschließbar ist.

Diese Aufgabe wird bei einer Decoder-Anschlußanordnung nach dem Oberbegriff des Patentanspruches 1 erfindungsgemäß dadurch gelöst, daß in der an den Bitleitung-Twist-Bereich angrenzenden Zone des Decoderbereiches zusätzliche Durchkontaktierungen zwischen den beiden Metallisierungsebenen vorgesehen sind.

Bei der erfindungsgemäßen Decoder-Anschlußanordnung sind also die beiden Metallisierungsebenen nicht wie bisher lediglich an beiden Enden des Decoderbereiches, sondern wenigstens ein weiteres Mal beispielsweise in dessen Mitte miteinander verbunden. Für eine flächenneutrale Realisierung dieser zusätzlichen Verbindung der beiden Metallisierungsebenen wird in vorteilhafter Weise die Zone des Decoderbereiches verwendet, die im Speicherzellenfeld dem Bitleitung-Twist-Bereich entspricht.

Außerdem wird durch den Bitleitung-Twist für die Bitleitungen deren Koppel-Kapazität infolge des Twistes praktisch halbiert, so daß die Bitleitungen länger als ohne Twist ausgeführt werden können. Zusätzlich ist es möglich, infolge der geringeren Koppel-Kapazität Leseverstärker (sense amplifier) einzusparen, da praktisch jeder zweite Leseverstärker weggelassen werden kann.

Durch die Erfindung ist es so möglich, die Stromversorgungsleitungen auf etwa ein Viertel ihrer bisherigen Dicke zu reduzieren oder die Länge des Decoderbereiches praktisch zu verdoppeln, ohne eine Verringerung der Schaltgeschwindigkeit durch höhere Kapazitäten bzw. RC-Konstanten in Kauf nehmen zu müssen.

Nachfolgend wird die Erfindung anhand der Zeichnungen näher erläutert. Es zeigen:
- Fig. 1: eine schematische Draufsicht auf eine Decoder-Anschlußanordnung nach einem Ausführungsbeispiel der Erfindung und
- Fig. 2: eine schematische Draufsicht auf eine bestehende Decoder-Anschlußanordnung.

Fig. 2 ist bereits eingangs erläutert worden. In Fig. 1 werden für einander entsprechende Teile die gleichen Bezugszeichen wie in Fig. 2 verwendet.

Im Unterschied zu der bestehenden Decoder-Anschlußanordnung von Fig. 2 führen bei der erfindungsgemäßen Decoder-Anschlußanordnung gemäß Fig. 1 die in x-Richtung verlaufenden Bitleitungen BL (nicht näher gezeigt) in einem Bitleitung-Twist-Bereich 8 jeweils einen Twist durch. Das heiß, zwei benachbarte Bitleitungen BL überkreuzen hier einander, so daß in dem Speicherzellenfeld 1 links von dem Bitleitung-Twist-Bereich 8 eine erste Bitleitung, die in Fig. 1 in y-Richtung oberhalb von einer zweiten Bitleitung verläuft, diese erste Bitleitung in dem rechts von dem Bitleitung-Twist-Bereich liegenden Teil des Speicherzellenfeldes 1 unterhalb der zweiten Bitleitung geführt ist, die hier nunmehr in y-Richtung oberhalb der ersten Bitleitung ist. Durch diesen Bitleitung-Twist wird bekanntlich infolge der elektrischen Symmetrie praktisch eine Halbierung der Koppel-Kapazität erreicht. Durch diese Halbierung der Koppel-Kapazität ist es möglich, praktisch jeden zweiten Leseverstärker wegzulassen.

Im Decoderbereich 2 besteht nun unterhalb des Bitleitung-Twist-Bereiches 8 ein Leer- bzw. Dummy-Bereich 7, in welchem infolge des Bitleitung-Twistes im Bereich 8 keine Decoder benötigt werden. Erfindungsgemäß wird dieser Bereich 7 nun für zusätzliche Durchkontaktierungen 6 zwischen der die Stromversorgungsleitungen 3 aufweisenden oberen Metallisierungsebene und der unteren Metallisierungsebene der Decoder ausgenutzt.

Die Breite des Bitleitung-Twist-Bereiches 8 beträgt beispielsweise etwa 2,4 µm, während das Speicherzellenfeld 1 links und rechts von diesem Bitleitung-Twist-Bereich 8 eine Breite von ca. 200 µm hat. Das heißt, das gesamte Speicherzellenfeld 1 hat eine Breite von knapp über 400 µm. Selbstverständlich können auch andere Zahlenwerte, bei höherem Technologieniveau beispielsweise kleinere Zahlenwerte, gewählt werden.

Der Dummy-Bereich 7 ist damit wie der Bitleitung-Twist-Bereich 8 ebenfalls etwa 2,4 µm breit. Diese Breite ist vollkommen ausreichend für die gewünschten Durchkontaktierungen zwischen den beiden Metallisierungsebenen. Durch diese zusätzliche Durchkontaktierungen 6 in dem Dummy-Bereich 7 wird eine niederohmige Verbindung zwischen den Stromversorgungsleitungen 3 und den Decodern im Decoderbereich 2 geschaffen.

Im Gegensatz zum Stand der Technik werden somit bei der erfindungsgemäßen Decoder-Anschlußanordnung die beiden Metallisierungsebenen nicht wie bisher nur an den beiden Enden des Bereiches 2 miteinander kontaktiert. Vielmehr wird eine solche Kontaktierung über die Durchkontaktierungen 6 auch in der Mitte des Bereiches 2 vorgenommen. Selbstverständlich ist es gegebenenfalls auch möglich, noch zusätzliche Durchkontaktierungen vorzusehen, wenn entsprechende weitere Dummy-Bereiche 7 verwendet werden. Außerdem ist die Erfindung nicht auf Zeilen-Decoder, also auf in Zeilenrichtung verlaufende Anordnungen begrenzt, wie dies in der Fig. 1 dargestellt ist. Vielmehr ist eine Anwendung der Erfindung auch in Spaltenrichtung möglich.

Der durch die Erfindung bedingte zusätzliche Flächenbedarf von etwa 2,4 µm ist äußerst gering. Überdies wird dieser zusätzliche Flächenbedarf durch die Einsparung an Fläche für Leseverstärker infolge des Twistes der Bitleitungen mehr als kompensiert.

## Patentansprüche

1. Decoder-Anschlußanordnung für Speicherchips mit:
- in einer ersten Richtung (x) verlaufenden langen Bitleitungen (BL),
- die Bitleitungen (BL) in einem Speicherzellenfeld (1) kreuzenden und in einer zweiten Richtung (y) verlaufenden Wortleitungen (WL),
- Wortleitungs-Decodern, die in einem Decoderbereich (2) liegen und eine erste Metallisierungsebene bilden, wobei der Decoderbereich (2) an einem in der ersten Richtung (x) verlaufenden Rand des Speicherzellenfeldes (1) angrenzt, und
- Versorgungsleitungen (3) für die Decoder, die im Decoderbereich (2) in einer über der ersten Metallisierungsebene liegenden zweiten Metallisierungsebene geführt sind, wobei zwischen den beiden Metallisierungsebenen jeweils Durchkontaktierungen (4, 5) an Seitenrändern des Decoderbereiches (2) vorgesehen sind, wobei im Speicherzellenfeld (1) die Bitleitungen (BL) in einem Bitleitung-Twist-Bereich (8) einen Twist bilden,
**dadurch gekennzeichnet daß**,
- in der an den Bitleitung-Twist-Bereich (8) angrenzenden Zone des Decoderbereiches (2) zusätzliche Durchkontaktierungen (6) zwischen den beiden Metallisierungsebenen vorgesehen sind.

2. Decoder-Anschlußanordnung nach Anspruch 1,
**dadurch gekennzeichnet, daß** die zusätzlichen Durchkontaktierungen (6) in einem Dummy-Bereich (7) des Decoderbereiches (2) liegen.

3. Decoder-Anschlußanordnung nach Anspruch 1 oder 2,
**dadurch gekennzeichnet, daß** der Bitleitung-Twist-Bereich eine Breite von etwa 2,4 µm hat.

4. Decoder-Anschlußanordnung nach einem der Ansprüche 1 bis 3,
**dadurch gekennzeichnet, daß** die Breite des Speicherzellenfeldes (1) in der ersten Richtung etwa 400 µm beträgt.

## Claims

1. Decoder connection arrangement for memory chips having:
- long bit lines (BL) running in a first direction (x),
- word lines (WL), which cross the bit lines (BL) in a memory cell array (1) and run in a second direction (y)
- word line decoders, which lie in a decoder region (2) and form a first metallization plane, the decoder region (2) adjoining an edge of the memory cell array (1) that runs in the first direction (x), and
- supply lines (3) for the decoder, which are routed in the decoder region (2) in a second metallization plane lying above the first metallization plane, respective plated-through holes (4, 5) being provided between the two metallization planes at lateral edges of the decoder region (2), the bit lines forming, in the memory cell array (1), (BL) a twist in a bit line twist region (8),
**characterized in that**
- **in that** zone of the decoder region (2) which adjoins the bit line twist region (8), additional plated-through holes (6) are provided between the two metallization planes.

2. Decoder connection arrangement according to Claim 1,
**characterized in that**
the additional plated-through holes (6) lie in a dummy region (7) of the decoder region (2).

3. Decoder connection arrangement according to Claim 1 or 2,
**characterized in that**
the bit line twist region has a width of approximately 2.4 µm.

4. Decoder connection arrangement according to one of Claims 1 to 3,
**characterized in that**
the width of the memory cell array (1) in the first direction is approximately 400 µm.

## Revendications

1. Connexion de décodeur pour puces de mémoire comprenant :
- de longues lignes (BL) de bits s'étendant dans une première direction (x),
- des lignes (WL) de mots croisant les lignes (BL) de bits dans un champ (1) de cellules de mémoire et s'étendant dans une deuxième direction (y),
- des décodeurs de lignes de mots, qui se trouvent dans une zone (2) de décodeur et qui forment un premier plan de métallisation, la zone (2) de décodeur étant voisine d'un bord du champ (1 ) de cellules de mémoire, qui s'étend dans la première direction (x), et
- des lignes (3) d'alimentation des décodeurs, qui passent dans la zone (2) de décodeur dans un deuxième plan de métallisation se trouvant au-dessus du premier plan de métallisation, des contacts (4, 5) traversants étant prévus entre les deux plans de métallisation sur des bords latéraux de la zone (2) de décodeur,
- les lignes (BL) de bits formant, dans le champ (1) de cellules de mémoire, dans une zone (8) de twist de ligne de bits, un twist,
**caractérisée en ce que**
- il est prévu dans la région, voisine de la zone (8) de twist de ligne de bits, de la zone de décodeur, des contacts (6) traversants supplémentaires entre les deux plans de métallisation.

2. Connexion de décodeur suivant la revendication 1,
**caractérisée en ce que** les contacts (6) traversants supplémentaires se trouvent dans une zone (7) fictive de la zone (2) de décodeur.

3. Connexion de décodeur suivant la revendication 1 ou 2,
**caractérisée en ce que** la zone de twist de ligne de bits a une largeur d'environ 2,4 µm.

4. Connexion de décodeur suivant l'une des revendications 1 à 3,
**caractérisée en ce que** la largeur du champ (1) de cellules de mémoire dans la première direction est d'environ 400 µm.
